# EUROPEAN PATENT SPECIFICATION

(11) **EP 4 501 455 B1**
(45) Date of publication and mention of the grant of the patent: **24.09.2025**
(21) Application number: 24173812.9
(22) Date of filing: 02.05.2024
(51) Int. Cl.: B01L 3/00, B29C 33/38, B33Y 80/00

(54) **A METHOD FOR CASTING A CHANNEL COMPONENT FOR USE IN MICROFLUIDIC DEVICES AND AN OPEN MOLD FOR CASTING A CHANNEL COMPONENT**
VERFAHREN ZUM GIESSEN EINER KANALKOMPONENTE ZUR VERWENDUNG IN MIKROFLUIDISCHEN VORRICHTUNGEN UND OFFENE FORM ZUM GIESSEN EINER KANALKOMPONENTE
PROCÉDÉ DE MOULAGE D'UN COMPOSANT DE CANAL DESTINÉ À ÊTRE UTILISÉ DANS DES DISPOSITIFS MICROFLUIDIQUES ET MOULE OUVERT POUR MOULER UN COMPOSANT DE CANAL

(30) Priority: 04.08.2023 CZ 20230030
(43) Date of publication of application: 05.02.2025
(73) Proprietor: Univerzita Karlova, 11000 Praha 1 (CZ)
(72) Inventor: Tuma, Petr, Cesky Brod (CZ)
(74) Representative: Sedlák, Jirí

(56) References cited:
- EP-A1- 2 312 321
- WO-A1-2018/005647
- WO-A2-2008/042482
- US-A1- 2015 137 429
- US-B2- 7 125 510
- HWANG YONGHA ET AL: "3D printed molds for non-planar PDMS microfluidic channels", vol. 226, 1 May 2015 (2015-05-01), NL, pages 137 - 142, XP093207867, ISSN: 0924-4247, Retrieved from the Internet <URL:https://batavia.internal.epo.org/citenpl/citation/prod/pdf/6cc96400-6743-3ab0-b82f-2d22864c6bc0.pdf> DOI: 10.1016/j.sna.2015.02.028
- F. OPEKARP. TUMA: "Dialysis of one sample drop on-line connected with electrophoresis in short capillary", TALANTA, vol. 219, 2020, pages 1 - 7, XP002812240, Retrieved from the Internet <URL:https://doi.org/10.1016/j.talanta.2020.121252.>
- ZHANG QIYANG ET AL: "Prototyping of poly(dimethylsiloxane) interfaces for flow gating, reagent mixing, and tubing connection in capillary electrophoresis", JOURNAL OF CHROMATOGRAPHY A, ELSEVIER, AMSTERDAM, NL, vol. 1324, 28 November 2013 (2013-11-28), pages 231 - 237, XP028807589, ISSN: 0021-9673, DOI: 10.1016/J.CHROMA.2013.11.043
- DEDIU VIOLETA ET AL: "PDMS Based Microfluidics Fabrication Using 3D-Printed Molds", 2022 INTERNATIONAL SEMICONDUCTOR CONFERENCE (CAS), IEEE, 12 October 2022 (2022-10-12), pages 243 - 246, XP034221858, DOI: 10.1109/CAS56377.2022.9934518
- JUNG WOOJUN ET AL: "Truly 3D microfluidic heating system with iterative structure of coil heaters and fluidic channels", SMART MATERIALS AND STRUCTURES, IOP PUBLISHING LTD., BRISTOL, GB, vol. 31, no. 3, 4 February 2022 (2022-02-04), XP020415476, ISSN: 0964-1726, [retrieved on 20220204], DOI: 10.1088/1361-665X/AC4E50
- MORBIOLI GIORGIO GIANINI ET AL: "A practical guide to rapid-prototyping of PDMS-based microfluidic devices: A tutorial", ANALYTICA CHIMICA ACTA, ELSEVIER, AMSTERDAM, NL, vol. 1135, 11 September 2020 (2020-09-11), pages 150 - 174, XP086297999, ISSN: 0003-2670, [retrieved on 20200911], DOI: 10.1016/J.ACA.2020.09.013

## Description

### Field of the Invention

The invention relates to a field of microfluidics, specifically to a method for casting a channel component for use in microfluidic devices and an open mold for casting a channel component.

### Background of the Invention

Microfluidics is a field that is related to the behaviour, precise control and manipulation of fluids that are geometrically limited to a small scale, typically less than a millimetre in size, where surface forces predominate over gravitational forces. It is a multidisciplinary field that involves engineering, physics, chemistry, biochemistry, nanotechnology and biotechnology. Typically, microfluidic systems transport, mix, separate, or otherwise process fluids and are of fundamental importance for combining analytical techniques such as capillary electrophoresis, liquid chromatography, spectrophotometry and mass spectrometry with on-line processing of complex samples such as clinical fluids, environmental and food samples [1].

For microfluidic systems, a number of channel components, the so-called flow gating interface (FGI), have been developed in recent years, where great progress has been made in the construction of various types of components made from available components and integrated connectors. A channel component means a component having a body made of a chemically resistant material, in which channels passing through the body of the component used for connection with analytical technique are arranged. They can also be called fittings, which is a common term in macrofluidics. These channel components are commercially available and are usually made of non-transparent materials such as polyetheretherketone (PEEK) or stainless steel in the shape of a cross, letter T or letter Y, and can be used for connecting capillaries and tubes.

It is much more convenient for the user to fabricate the channel components for use in microfluidic devices directly in the laboratory. Soft lithography is used for this purpose, which is quite complex, financially demanding technique and requires highly specialized equipment, including operation in clean laboratory conditions. It is based on silicon wafers, on which a photoresist is applied, this is illuminated through a photomask, then etched, creating a negative as a mold for casting. The mold is filled with the polymerization mixture and allowed to harden, then the casting as a system of channels is removed from the mold, and the channels need to be closed from above with a cover film, which will be connected with the casting.

A much simpler technique for fabricating channel components for use in microfluidic devices, i.e. for connecting capillaries, manufacturing microreactors, mixing elements, connecting microdialysis with analytical technique, was described in Articles [2] and [3]. Here, the authors used a Petri dish as a mold, into which silon fibres or metal wires were threaded from the side and fixed them in the crossing with pliers. A polymerization mixture of polydimethylsiloxane (PDMS) was poured into the mold thus created and was heat hardened. The fibres and wires were then pulled out from the side, the PDMS channel component was taken out of the dish and used it as a fitting in capillary electrophoresis.

In an innovative procedure [4] for the fabrication of channel components for use in microfluidic devices, a frame is cut out of a silicone foil, which is placed on a glass plate, and tubes and capillaries of different diameters are inserted from the side into the mold thus created and fixed at joints by UV hardenable adhesive. Subsequently, PDMS is poured into the mold and allowed to heat harden. Then the tubes and capillaries are pulled out from the side again and the resulting PDMS channel component is used as a fitting in capillary electrophoresis.

The disadvantages of the known methods of casting channel components are mainly the complexity of the preparatory steps, such as modification of the Petri dish or cutting of the silicone foil, fixing of wires or capillaries in precise positions, searching for construction materials with an appropriate diameter, and they have major limitations on the creation of microstructures. These preparatory steps are time-consuming and material-intensive, making the entire fabrication process of channel components for use in microfluidic devices more expensive and longer. In addition, only one channel component is prepared in this way, although in practice a larger number of channel components are needed in experiments, so the fabrication of several channel components takes a long time and their fabrication is very inefficient and, above all, non-reproducible. Channel components prepared by known methods also have large channel diameters, because tubes, hoses or capillaries are used as casting cores to create the channels, the diameters of which are too large for use in microanalytical techniques, thereby limiting miniaturization and compromising the watertight integrity of the entire subsequent analytical process.

The object of the invention is therefore to create such a method for casting channel components for use in microfluidic devices, which would eliminate the above-mentioned shortcomings, which would be materially, economically and time-efficient, which would enable the fabrication of very fine structures of channel components with diameters from 50 µm and above, which would then be used for assembling microfluidic elements with a high variability of designs, whose series production is characterized by high reproducibility.
[1] P. Tůma, Progress in on-line, at-line, and in-line coupling of sample treatment with capillary and microchip electrophoresis over the past 10 years: A review, Anal. Chim. Acta 1261 (2023), https://doi.org/10.1016/j.aca.2023.341249.
[2] Q.Y. Zhang, M.J. Gong, Prototyping of poly(dimethylsiloxane) interfaces for flow gating, reagent mixing, and tubing connection in capillary electrophoresis, J. Chromatogr. A 1324 (2014) 231-237, https://doi.org/10.1016/j.chroma.2013.11.043.
[3] M.J. Gong, N. Zhang, N. Maddukuri, Flow-gated capillary electrophoresis: a powerful technique for rapid and efficient chemical separation, Anal. Methods 10 (2018) 3131-3143, https://doi.org/10.1039/c8ay00979a.
[4] F. Opekar, P. Tůma, Dialysis of one sample drop on-line connected with electrophoresis in short capillary, Talanta 219 (2020) 1-7, https://doi.org/10.1016/j.talanta.2020.121252.

### Summary of the Invention

The object is achieved by using a method for casting a channel component for use in microfluidic devices according to the present invention. In this method, at least one core is inserted into the open mold for casting the channel, then a heat-curable polymerization mixture containing polydimethylsiloxane is poured into the mold, which is subsequently hardened by applying elevated temperature to form polydimethylsiloxane, and then the core is removed from the mold.

The core of the present invention is that the mold and the core are prepared by 3D printing by photopolymerization as a single integral body of UV hardenable resin, then washed, dried and hardened by UV radiation, and after pouring and hardening of polydimethylsiloxane, the walls and bottom of the mold are mechanically removed, and the core is removed from the body of the channel part by pulling. Using 3D printing by photopolymerization, the mold can be reproducibly created with any design of channel components and with very fine structures.

In a preferred embodiment, the core has the shape of a fibre of full circular cross-section from 50 µm to 1500 µm in diameter.

The fibre is preferably formed by an assembly of cylinders with a diameter graduated in size from the wall of the mold, while the diameter of the smallest cylinder in the middle of the mold is between 50 µm and 100 µm. The diameters of channel components are intentionally gradually narrowed from the entry towards the inside, which ensures easy insertion of the capillary or tube into the channel component and at the same time the watertight integrity of the resulting connection. Capillaries can be repeatedly moved in and out of the inlets or channels of microfluidic components.

In one preferred embodiment, the mold has fibres arranged in the shape of a cross to form a cross-piece, which is used for casting a channel component with three inlets and one outlet and serves to mix solutions and fluids from three sources; or with two inlets and two outlets, which has one inlet for the sample supply, one outlet to the analytical device, one inlet for the auxiliary fluid, and one outlet to the waste, and serves as an FGI.

In another preferred embodiment, the mold has fibres arranged in the shape of the letter "T" to form a T-piece, which is used for casting a channel component with two inlets and one outlet for mixing two fluids; or one inlet and two outlets, and functions as a flow splitter.

Fused silica capillaries, glass, plastic or metal tubes with outer diameters between 100 µm and 1.5 mm can be inserted from the side into the finished channel components, and due to the flexibility of PDMS, a watertight connection is created without the need for additional sealing elements.

Using 3D printing by photopolymerization, a series of up to twenty-eight molds is preferably prepared in 22 minutes during one printing cycle. The series preparation of the molds of channel components represents a significant simplification of the preparatory steps in experiments using microfluidic devices, both in terms of time, material, and economy.

In a preferred embodiment, the hardened channel component is modified by silanization as effective surface treatment. By silanization, the hydrophobic surface of PDMS hydrophilizes and becomes more water-wettable, thereby minimizing the adhesion of air bubbles on the inner surface.

The subject of the invention is also an open mold for casting a channel component for use in microfluidic devices. The core of the present invention is that the walls, bottom and cores for casting channels are made of UV hardenable resin for 3D printing, and the core has the form of a fibre with a solid circular cross-section with a dimeter between 50 µm and 1500 µm. The use of 3D printing by photopolymerization in the preparation of an open mold for casting a channel component provides a fast, cheap and efficient method for creating a mold with a very fine core structure, i.e. for creating a channel component with a very fine channel structure.

The fibre is preferably formed by an assembly of cylinders with a diameter graduated in size from the wall of the mold, while the diameter of the smallest cylinder in the middle of the mold is up to 50 µm. In one preferred embodiment, the mold has fibres arranged in the shape of a cross to form a cross-piece with three inlets and one outlet or two inlets and two outlets. In another preferred embodiment, the mold has fibres arranged in the shape of the letter "T" to form a T-piece with two inlets and one outlet or one inlet and two outlets.

The advantages of the method for casting a channel component for use in microfluidic devices and an open mold for casting a channel component according to the present invention are mainly that they are materially, economically and time-efficient, the mentioned method enables the fabrication of very fine structures of channel components with small diameters of channels in addition to various designs for highly reproducible series production, they can therefore be used for a wide range of analytical methods.

### Explanation of drawings

The present invention will be explained in detail by means of the following figures where:
- Fig. 1: shows a view of the cross-piece mold,
- Fig. 2: shows a section of the cross-piece mold,
- Fig. 3: shows a channel component in the cross-piece mold,
- Fig. 4: shows a view of the FGI mold,
- Fig. 5: shows a section of the FGI mold,
- Fig. 6: shows a channel component in the FGI mold,
- Fig. 7: shows a view of the T-piece mold,
- Fig. 8: shows a section in the T-piece mold,
- Fig. 9: shows a channel component in the T-piece mold.

### Example of the invention embodiments

### Drawings of channel components

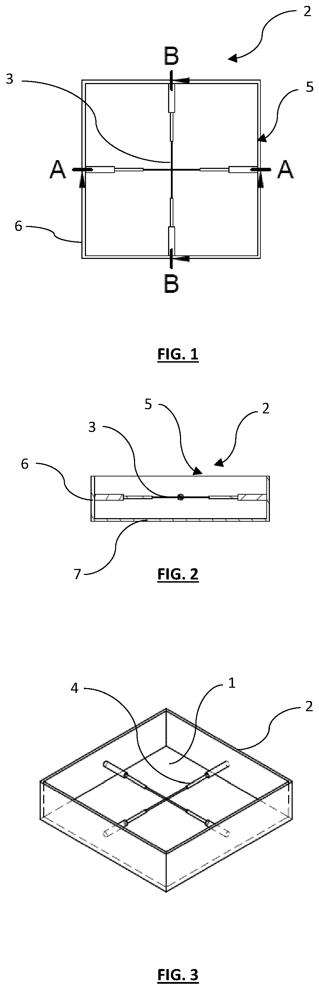

Molds 2 for casting channel components 1 for use in microfluidic devices are drawn in the graphic design software Autodesk-123D-Design (or in another CAD software). The molds 2 are open at the top and have internal dimensions of 12 x 12 x 3 mm and are formed by a bottom 7 and side walls 6, i.e. they are in the shape of a square with dimensions of 12 x 12 mm and the height of the side wall 6 is 3 mm. The walls 6 have a thickness of 200 µm and an assembly of fibres forming the core 3 of the mold 2 of different diameters is stretched between them. The fibre has a solid circular cross-section and is formed by an assembly of cylinders of different diameters, where the widest cylinder is at the wall 6 of mold 2 and the thinnest cylinder is in the centre of mold 2. Fig. 1 to Fig. 9 show the three most common examples of channel components 1.

### Stereolithography (SLA) 3D printing

Autodesk drawings of mold 2 are imported into the slicing program for the Original Prusa SL1S SPEED 3D printer. This is stereolithography (SLA) 3D printing from UV hardenable resin, specifically Prusament Resin Tough Prusa Orange is used.

Setting-3D-printing-pad: during one cycle, up to 28 molds 2 of the above-mentioned dimensions can be printed in the same time as one product, which is suitable for series production. Specifically, 28 channel components 1 are printed on the basis of a cross-piece with a duration of 21 minutes and 16 seconds.

Setting-3D-printing-layer: printings takes place after the minimum possible single layer thickness of 25 µm and no product supports and pads are used.

Setting-3D-printing-material: the exposure time for the layer is set to 5 seconds and to 45 seconds for the first 10 layers. These are longer exposure times than recommended by the manufacturer in order to print details in the form of thin fibres.

### Example 1: CROSS-piece

The mold 2 has a core 3, the fibres of which are arranged in the shape of a cross, to form a channel component 1, the so-called cross-piece, which has three inlets and one outlet, as shown in Fig. 1 to Fig. 3. Fig. 1 and section A-A in Fig. 2 show the core 3, which is formed by an assembly of cylinders that are graduated in size. The widest cylinders that touch the side walls 6 have a length of 2 mm and a diameter of 0.4 mm, the middle cylinders following the widest cylinders have a length of 2 mm and a diameter of 0.2 mm, and the thinnest cylinders following the middle cylinders have a length of 2 mm and a diameter 0.1 mm. The thinnest cylinders touch each other in the centre of mold 2, where fluids are mixed. Fig. 3 shows the mold 2 with a core 3 in which a channel component 1 with a channel 4 is cast.

The cross-piece serves as a cross microfluidic mixer for connecting four fused silica capillaries with an outer diameter of 360 µm; solutions enter the channel component 1 through three capillaries, which are mixed in the cross, and the mixture exits the channel component 1 through the fourth capillary. In another embodiment, a different capillary or tube of a different diameter may be used.

### Example 2: FGI-piece - flow gating interface

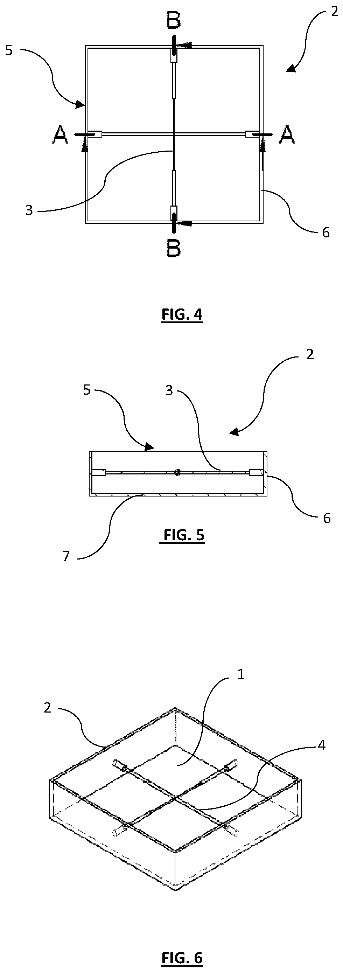

The mold 2 has a core 3, the fibres of which are arranged in the shape of a cross, to form a channel component 1, the so-called flow gating interface, which has one inlet for the sample supply and one outlet to the analytical device and one inlet for the auxiliary fluid and one outlet to the waste, as shown in Fig. 4 to Fig. 6. Fig. 4 and section in Fig. 5 show the core 3, which is formed by an assembly of cylinders that are graduated in size. In the horizontal fibre, the widest cylinders that touch the side walls 6 have a length of 1 mm and a diameter of 0.4 mm, the middle cylinders following the widest cylinders have a length of 2.5 mm and a diameter of 0.2 mm, and the thinnest cylinders following the middle cylinders have a length 2.5 mm and a diameter of 0.1 mm. In the vertical fibre, the widest cylinders that touch the side walls 6 have a length of 1 mm and a diameter of 0.4 mm, and the thinnest cylinders following the widest cylinders have a length of 5 mm and a diameter of 0.2 mm. The thinnest cylinders of the horizontal fibre and the vertical fibre touch in the centre of mold 2 and the fluids mix here. Fig. 6 shows the mold 2 with a core 3 in which a channel component 1 with a channel 4 is cast.

The cross flow-gating interface works on the principle that two fused silica capillaries are inserted horizontally into the channels 4 facing each other, one as an inlet to capillary electrophoresis and the other supply the sample from, for example, microdialysis. The gating solution flows through the vertical channel 4 and this channel 4 is watertight-connected to two tubes with a diameter of 900 µm.

The FGI piece is used for on-line connection of the analytical technique of capillary electrophoresis with the flow-through sampling technique, such as microdialysis or flow injection analysis, etc. In the FGI, the inlet into the injection end of the electrophoretic capillary and the outlet of the tube continuously supply the sample are placed opposite each other in the horizontal channel 4. In the basic mode of operation of the FGI, an auxiliary fluid flows through the vertical wider channel 4, which diverts the sample from the entry to the capillary electrophoresis and drains it to the waste. In injection mode, the flow of auxiliary fluid is stopped by closing the upstream valve, allowing the sample to accumulate in the crossing and inject it into the electrophoretic capillary. Subsequently, the flow of auxiliary fluid is restored, and the sample is removed into the waste and electrophoretic analysis takes place.

### Example 3: T-piece

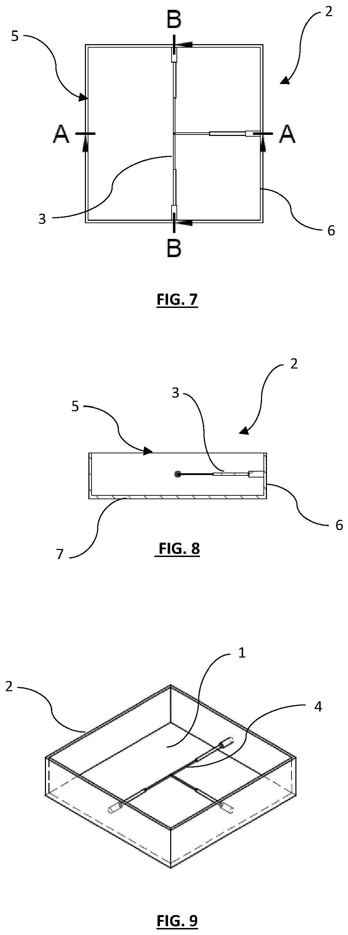

The mold 2 has a core 3, the fibres of which are arranged in the shape of the letter "T", to form a channel component 1, which has two inlets and one outlet, as shown in Fig. 7 to Fig. 9. Fig. 7 and section in Fig. 8 show the core 3, which is formed by an assembly of cylinders that are graduated in size. The widest cylinders that touch the side walls 6 have a length of 1 mm and a diameter of 0.4 mm, the middle cylinders following the widest cylinders have a length of 2.5 mm and a diameter of 0.2 mm, and the thinnest cylinders following the middle cylinders have a length of 2.5 mm and a diameter 0.1 mm. The thinnest cylinders touch each other in the centre of mold 2, where fluids are mixed. Fig. 9 shows the mold 2 with a core 3 in which a channel component 1 with a channel 4 is cast.

The T-piece serves as a three-way microfluidic mixer with two inlet and one outlet of fused silica capillaries with an outer diameter of 360 µm. In another embodiment, a different capillary or tube of a different diameter may be used.

### Hardening of 3D molds

After the printing is finished, the printing pad and molds 2 are ejected from the 3D printer and immersed in a washing bath with isopropanol and allowed to be washed for 15 minutes. The washed pad and molds 2 are dried with an air flow, then the 3D prints are removed from the pad and placed in a hardening station, where they are allowed to dry for 15 minutes at a temperature of 60 °C and then hardened by UV radiation for 30 minutes. The result is finished molds 2.

### Casting of channel components from PDMS

The channel components 1 are cast into the prepared mold 2 from polydimethylsiloxane, which is a flexible material showing transparency in the UV and visible region of the spectrum for potential use in optical analytical techniques. Prior to casting, the principal component of RTV 615 silicone rubber is mixed in a beaker with a hardening reagent, through which the linear chains are cross-linked into a spatial lattice, in the ratio of 10:1 to form a polymerization mixture.

The mixture is allowed to stand for approximately 30 minutes for air bubbles to rise up spontaneously, and then it is poured into molds 2 up to the top edge; three molds 2 are filled with 1 mL of the polymerization mixture. Molds 2 are placed in a hot air dryer and allowed to polymerize at a temperature of 60 °C for 1 hour.

After hardening and cooling, the PDMS casting, i.e. the hardened channel component 1, is removed from the mold 2 using a scalpel, and then the individual fibres of the core 3 are removed from the channels 4 using tweezers. Any stuck fibre fragments can be pushed out from the side using a thin capillary.

The hardened channel component, without the mold and all its fragments, is subsequently subjected to surface silanization applied to the PDMS, which is carried out by inserting the hardened channel component into the silanizing reagent of 3-glycidyloxypropyl-trimethoxysilane and leaving it in an ultrasonic bath for 1 to 2 hours. It is then washed with isopropanol and then with deionized water.

### Industrial applicability

The method for casting a channel component for use in microfluidic devices and the open mold for casting a channel component according to the present invention can be used when using multiple channel components in microfluidic systems is needed.

### List of index reference numerals

- 1: channel component
- 2: mold
- 3: core
- 4: channel
- 5: body
- 6: wall
- 7: bottom

## Claims

1. A method for casting a channel component (1) for use in microfluidic devices, in which at least one core (3) is inserted into an open mold (2) for casting a channel (4), then heat-curable polydimethylsiloxane is poured into the mold (2), which is subsequently heat-hardened and then the core (3) is removed from the mold (2), **characterized in that** both the mold (2) and the core (3) are prepared by 3D printing by photopolymerization as a single integral body (5) of UV hardenable resin, subsequently washed, dried and hardened by UV radiation, and after pouring and hardening of the polydimethylsiloxane, the walls (6) and bottom (7) of the mold (2) are mechanically removed, and the core (3) is removed from the body (5) of the channel part (1) by pulling.

2. The method of claim 1, **characterized in that** the core (3) has the form of a fibre with a solid circular cross-section with a dimeter between 50 µm and 1500 µm.

3. The method of claim 2, **characterized in that** the fibre is formed by an assembly of cylinders with a diameter graduated in size from the wall (6) of the mold (2), while the diameter of the smallest cylinder in the middle of the mold is between 50 µm and 100 µm.

4. The method of any of claims 1 to 3, **characterized in that** the mold (2) has fibres arranged in the shape of a cross to form a cross-piece, which is used for casting a channel component (1) with three inlets and one outlet or a channel component (1) with two inlets and two outlets.

5. The method of any of claims 1 to 3, **characterized in that** the mold (2) has fibres arranged in the shape of the letter "T" to form a T-piece, which is used for casting a channel component (1) with two inlets and one outlet or a channel component (1) with one inlet and two outlets.

6. The method of any of claims 1 to 5, **characterized in that** a series of twenty-eight molds (2) is prepared using 3D printing by photopolymerization in 22 minutes during one printing cycle.

7. The method of any of claims 1 to 6, **characterized in that** the hardened channel component (1) is modified by silanization.

8. An open mold (2) for casting a channel component (1) for use in microfluidic devices, **characterized in that** the walls (6), bottom (7) and cores (3) for casting the channels (4) are made of UV hardenable resin for 3D printing and the core (3) has the form of a fibre with a solid circular cross-section with a diameter between 50 µm and 1500 µm.

9. The open mold (2) of claim 8, **characterized in that** the fibre is formed by an assembly of cylinders with a diameter graduated in size from the wall (6) of the mold (2), while the diameter of the smallest cylinder in the middle of the mold (2) is between 50 µm and 100 µm.

10. The open mold (2) of claim 8 or 9, **characterized in that** the mold (2) has fibres arranged in the shape of a cross to form a cross-piece with three inlets and one outlet or with two inlets and two outlets.

11. The open mold (2) of claim 8 or 9, **characterized in that** the mold (2) has fibres arranged in the shape of the letter "T" to form a T-piece with two inlets and one outlet or one inlet and two outlets.

## Patentansprüche

1. Das Verfahren zum Gießen von einer Kanalkomponente (1) zur Verwendung in mikrofluidischen Vorrichtungen, bei dem zum Gießen von einem Kanal (4) mindestens ein Kern (3) in eine offene Form (2) eingelegt wird, anschließend ein wärmehärtbares Polydimethylsiloxan in die Form (2) gegossen wird, welches anschließend thermisch ausgehärtet wird und anschließend der Kern (3) aus der Form (2) entnommen wird, **dadurch gekennzeichnet, dass** sowohl die Form (2), als auch der Kern (3) durch den Photopolymerisations-3D-Druck als ein einziger integraler Körper (5) aus UV-härtbarem Harz vorbereitet werden, anschließend wird er gewaschen, getrocknet und durch UV-Strahlung ausgehärtet, und nach dem Eingießen und Aushärten des Polydimethylsiloxans werden die Wände (6) und der Boden (7) der Form (2) mechanisch entfernt und der Kern (3) durch Herausziehen aus dem Körper (5) der Kanalkomponente (1) entfernt.

2. Das Verfahren nach dem Anspruch 1, **dadurch gekennzeichnet, dass** der Kern (3) die Form einer Faser mit einem vollkreisförmigen Querschnitt und einem Durchmesser von 50 µm bis 1500 µm aufweist.

3. Das Verfahren nach dem Anspruch 2, **dadurch gekennzeichnet, dass** die Faser durch eine Anordnung von Zylindern gebildet wird, deren Durchmesser von der Wand (6) der Form (2) weg in der Größe abgestuft ist, wobei der Durchmesser des kleinsten Zylinders in der Mitte der Form (2) zwischen 50 µm und 100 µm liegt.

4. Das Verfahren nach einem der Ansprüche 1 bis 3, **dadurch gekennzeichnet, dass** die Form (2) kreuzförmig angeordnete Fasern aufweist, die eine kreuzförmige Kupplung bilden, wodurch eine Kanalkomponente (1) mit drei Einlässen und einem Auslass oder eine Kanalkomponente (1) mit zwei Einlässen und zwei Auslässen abgegossen wird.

5. Das Verfahren nach einem der Ansprüche 1 bis 3 **dadurch gekennzeichnet, dass** die Form (2) T-förmig angeordnete Fasern aufweist, die eine 3-Wege-Kupplung bilden, wodurch eine Kanalkomponente (1) mit zwei Einlässen und einem Auslass oder eine Kanalkomponente (1) mit einem Einlass und zwei Auslässen abgegossen wird.

6. Das Verfahren nach einem der Ansprüche 1 bis 5, **dadurch gekennzeichnet, dass** durch den Photopolymerisations-3D-Druck Achtundzwanzig Formen (2) seriell innerhalb von 22 Minuten während eines Druckzyklus vorbereitet werden.

7. Das Verfahren nach einem der Ansprüche 1 bis 5, **dadurch gekennzeichnet, dass** die ausgehärtete Kanalkomponente (1) durch die Silanisierung nachbehandelt wird.

8. Offene Form (2) zum Gießen von einer Kanalkomponente (1) zur Verwendung in mikrofluidischen Vorrichtungen, **dadurch gekennzeichnet, dass** die Wände (6), der Boden (7) und die Kerne (3) zum Gießen von Kanälen (4) aus UV-härtbarem Harz für den 3D-Druck bestehen und der Kern (3) die Form einer Faser mit einem vollkreisförmigen Querschnitt und einem Durchmesser von 50 µm bis 1500 µm aufweist.

9. Offene Form (2) nach dem Anspruch 8, **dadurch gekennzeichnet, dass** die Faser durch eine Anordnung von Zylindern gebildet wird, deren Durchmesser von der Wand (6) der Form (2) weg in der Größe abgestuft ist, wobei der Durchmesser des kleinsten Zylinders in der Mitte der Form (2) zwischen 50 µm und 100 µm liegt.

10. Offene Form (2) nach dem Anspruch 8 oder 9, **dadurch gekennzeichnet, dass** die Form (2) kreuzförmig angeordnete Fasern aufweist, die eine kreuzförmige Kupplung mit drei Einlässen und einem Auslass oder mit zwei Einlässen und zwei Auslässen bilden.

11. Offene Form (2) nach dem Anspruch 8 oder 9, **dadurch gekennzeichnet, dass** die Form (2) T-förmig angeordnete Fasern aufweist, die eine 3-Wege-Kupplung mit zwei Einlässen und einem Auslass oder mit einem Einlass und zwei Auslässen bilden.

## Revendications

1. Le procédé de moulage d'un composant de canal (1) destiné à être utilisé dans des dispositifs microfluidiques, dans lequel au moins un noyau (3) destiné à mouler un canal (4) est inséré dans un moule ouvert (2), puis un polydiméthylsiloxane thermodurcissable est coulé dans le moule (2), qui est ensuite durci thermiquement, puis le noyau (3) est retiré du moule (2), **caractérisée en ce que** le moule (2) et le noyau (3) sont préparés par impression 3D par photopolymérisation sous la forme d'un corps intégral unique (5) à partir d'une résine UV, qui est ensuite lavé, séché et durci par rayonnement UV, et après le coulage et le durcissement du polydiméthylsiloxane, les parois (6) et le fond (7) du moule (2) sont retirés mécaniquement, et le noyau (3) est retiré du corps (5) du composant de canal (1) en le tirant vers l'extérieur.

2. Le procédé selon la revendication 1, **caractérisé en ce que** le noyau (3) a la forme d'une fibre à section transversale circulaire pleine d'un diamètre de 50 µm à 1500 µm.

3. Le procédé selon la revendication 2, **caractérisé en ce que** la fibre est formée par un assemblage de cylindres dont le diamètre est gradué en taille dans la direction allant de la paroi (6) du moule (2), le diamètre du plus petit cylindre au milieu du moule (2) étant compris entre 50 µm et 100 µm.

4. Le procédé selon l'une des revendications 1 à 3, **caractérisé en ce que** la forme (2) comporte des fibres disposées en croix pour former un couplage croisé, grâce auquel un composant de canal (1) avec trois entrées et une sortie ou un composant de canal (1) avec deux entrées et deux sorties est moulé.

5. Le procédé selon l'une des revendications 1 à 3, **caractérisé en ce que** la forme (2) comporte des fibres disposées en forme de T pour former un couplage à trois voies, grâce auquel un composant de canal (1) avec deux entrées et une sortie ou un composant de canal (1) avec une entrée et deux sorties est moulé.

6. Le procédé selon l'une des revendications 1 à 5, **caractérisé en ce que** vingt-huit moules (2) sont préparés en série par photopolymérisation par impression 3D en 22 minutes au cours d'un seul cycle d'impression.

7. Le procédé selon l'une des revendications 1 à 6, **caractérisé en ce que** le composant de canal durci (1) est traité par silanisation.

8. Le moule ouvert (2) pour couler des composants de canal (1) destinés à être utilisés dans des dispositifs microfluidiques, **caractérisé en ce que** les parois (6), le fond (7) et les noyaux (3) pour le moulage de canaux (4) sont réalisés en résine UV pour l'impression 3D, et le noyau (3) a la forme d'une fibre à section transversale circulaire pleine d'un diamètre allant de 50 µm à 1500 µm.

9. Le moule ouvert (2) selon la revendication 8, **caractérisé en ce que** la fibre est formée par un assemblage de cylindres dont le diamètre est gradué en taille dans la direction allant de la paroi (6) du moule (2), le diamètre du plus petit cylindre au milieu du moule (2) étant compris entre 50 µm et 100 µm.

10. Le moule ouvert (2) selon la revendication 8 ou 9, **caractérisé en ce que** le moule (2) comporte des fibres disposées en forme de croix pour former un raccord en croix avec trois entrées et une sortie ou avec deux entrées et deux sorties.

11. Le moule ouvert (2) selon la revendication 8 ou 9, **caractérisé en ce que** le moule (2) comporte des fibres disposées en forme de T pour former un couplage à trois voies avec deux entrées et une sortie ou une entrée et deux sorties.
